# EUROPEAN PATENT SPECIFICATION

(11) **EP 4 027 502 B1**
(45) Date of publication and mention of the grant of the patent: **27.08.2025**
(21) Application number: 21218137.4
(22) Date of filing: 29.12.2021
(51) Int. Cl.: H02K 11/33, H05K 1/02, H05K 7/14, H02K 11/40, H05K 9/00

(54) **A CONVEYOR DRIVE UNIT AND A CONVEYOR**
FÖRDERERANTRIEBSEINHEIT UND FÖRDERER
UNITÉ D'ENTRAÎNEMENT DE CONVOYEUR ET CONVOYEUR

(30) Priority: 08.01.2021 FI 20215022; 18.01.2021 FI 20215059
(43) Date of publication of application: 13.07.2022
(73) Proprietor: KONE Corporation, 00330 Helsinki (FI)
(72) Inventor: NAKARI, Arto, 05810 Hyvinkää (FI); POKKINEN, Olli, 00330 Helsinki (FI)
(74) Representative: Kallioniemi, Antti Sakari

(56) References cited:
- EP-A1- 3 016 488
- CN-U- 204 529 031
- CN-U- 206 884 778
- JP-B2- 4 595 251
- US-A1- 2006 203 453
- US-A1- 2008 055 861
- US-A1- 2012 262 878
- US-A1- 2015 036 280
- US-A1- 2016 270 206

## Description

### Field of the invention

This invention concerns a conveyor drive unit for driving a conveyor drive machine.

### Background

A conveyor, such as an elevator, an escalator or a moving walk, is driven by a conveyor drive machine, which provides required momentary amount of driving torque or propulsion force for operating the conveyor in different operating situations. Conveyor drive machine has a conveyor drive motor, i.e. an electrical motor, such as an induction motor or a permanent magnet motor. Drive machine is operated by feeding electrical power to the windings of the conveyor drive motor with a conveyor drive unit, such as a frequency converter.

EP 3 016 488 A1 discloses a conveyor drive unit for driving a conveyor drive machine. It has a main circuit board, a grounding plate and a housing enclosing the main circuit board and the grounding plate. Main circuit board comprises a power component module with IGBT transistors, a drive circuit of the IGBT transistors and a heat sink adapted for cooling the IGBT transistors. CN 204 529 031 U discloses another conveyor drive unit with a main circuit board, a grounding plate and a housing enclosing the main circuit board.

US 2008/055861 A1 discloses an electronic appliance, which comprises a grounding plate having a void and a heat sink. Heat sing extends via the void to the other side of the grounding plate.

### Summary

This invention represents a compact and space-efficient conveyor drive unit which can be easily fitted into a conveyor within a built-up environment. The conveyor drive unit also has good EMC properties, thus fulfilling EMC regulations required for operation of the conveyor. An elevator drive unit, an escalator drive unit and a moving walk drive unit are exemplary embodiments of the conveyor drive unit.

### Detailed description of the invention

In the following, embodiments of the invention will be discussed with reference to the following drawings:
Figure 1, representing mechanical structure of the inventive conveyor drive unit. Figure 1 presents an exploded view of the conveyor drive unit and as an oblique top view.
Figure 2, representing the drive unit of Fig. 1 as an oblique top view and from opposite direction to fig. 1. Figure 3, representing the drive unit of Fig. 2 with the front plate 14 installed.

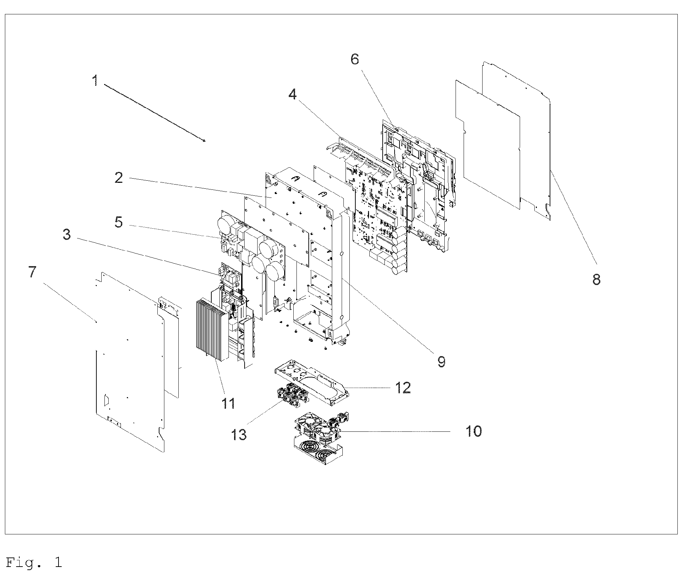

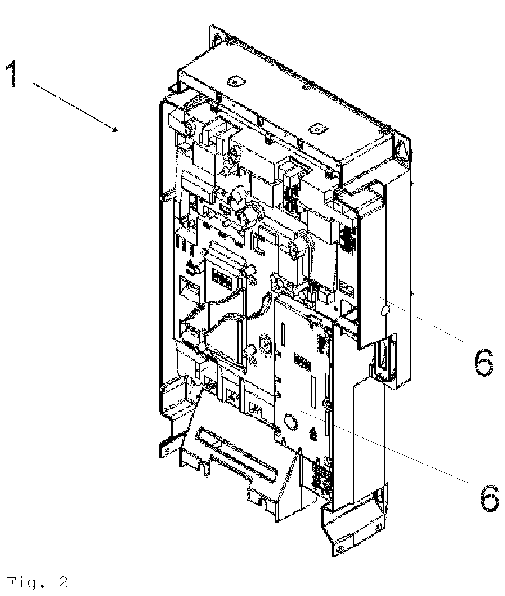

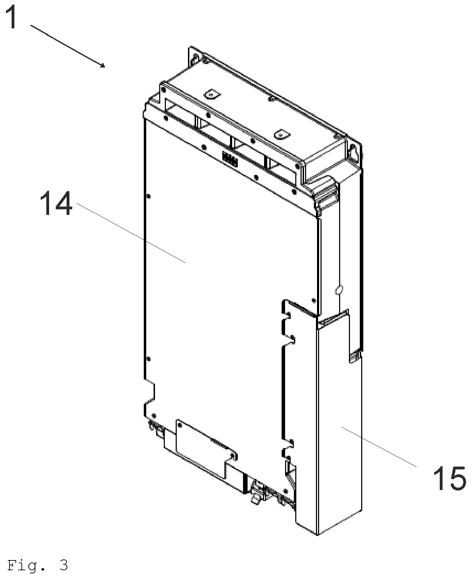

Figures 1, 2 and 3 are drawn to scale.

Same reference numbers are used for similar items throughout the drawings.

The conveyor drive unit disclosed in the exemplary embodiments provides economic, flat design beneficial for conveyors, in particular for machine roomless elevators. The flat drive unit is easy to fit into narrow spaces inside elevator shaft, such as adjacent to shaft wall, outside of the elevator car trajectory. The conveyor drive unit 1 in figs. 1 - 3 is configured for driving a conveyor drive machine. Conveyor drive machine comprises necessary components, such as an electrical motor, a traction sheave of an elevator or a driving gear for an endless belt of an escalator or a moving walk, for operating the respective conveyor.

The conveyor drive unit 1 comprises a main circuit board 4 and a conveyor movement control board attached on top of the main circuit board 4 (the conveyor movement control board not represented in figures). Alternatively, control components of the conveyor movement control board may be mounted on the main circuit board 4. Main circuit board 4 comprises power components, at least igbt - power transistors or mosfet - power transistors, constituting rectifier bridge and motor inverter bridge topology of a frequency converter. Main circuit board 4 also comprises driver circuit, i.g. igbt -drivers or mosfet-drivers of the power transistors, as well as DC link capacitors of the frequency converter. By switching of these power transistors, a variable-frequency, variable-amplitude voltage may be generated for conveyor drive motor. Switching reference of the transistors is calculated in the conveyor movement control board, such that conveyor movement, e.g. elevator car movement follows a desired movement profile.

A grounding plate 2 is fitted inside the housing of the conveyor drive unit 1, such that is separates an interior of the housing into two different portions. A line filter board 5 and a backup battery control board 3 are attached to the grounding plate 2 on the opposite side as the main circuit board 4 and the conveyor movement control board.

Grounding plate 2 is made of metal, preferably by casting. The grounding plate 2 comprises a side profile 9 extending perpendicularly from opposite edges of the grounding plate 2. Side profiles 9 form side surfaces of the housing, whereas front plate 14 and back plate 7 form front and back surfaces of the housing, respectively. This way a tight housing can be achieved, having environmental protection with at least of IP23 class.

The line filter board 5 is placed in the same housing portion with the backup battery control board 3. It comprises filtering components, such as inductors and capacitors used for filtering line current of the frequency converter.

Some interface components (isolators) and filtering components (capacitors, such as Y-capacitors of switched-mode power supplies) in the main circuit board are electrically connected to the grounding plate 2. The conveyor movement control board and the line filter board 5 are electrically connected to the grounding plate 2 as well. This kind of grounding solution prevents or reduces circulating currents and common-mode disturbance, improving EMC properties of the conveyor drive unit.

The front 14 and back 7 plates of the housing may be made of plastic or metal,e.g. by casting.

External cables, such as line supply cables and motor cables are connected to the drive unit 1 by means of plug connectors 13.

Further, the grounding plate 2 comprises a void. The main circuit board 4 comprises a heat sink adapted for cooling the power transistors. The main circuit board 4 is attached to one side of the grounding plate 2 such that heatsink of the power transistors extends via the void to the other side of the grounding plate 2. A fan unit 10, which comprises at least one, preferably two fans, performs convective cooling of the components of the main circuit board 4, line filter board 5, backup battery control board 3 and conveyor movement control board. A diffusing plate is adapted to divide air flow from the fan unit 10 into two sections directed to opposite sides of the grounding plate 2 such that convective cooling is achieved for components on both sides of the grounding plate 2.

Plug connectors 13 and fan unit 10 are introduced into the bottom of the drive unit 1 via an interface unit 12.

The specific examples provided in the description given above should not be construed as limiting the applicability and/or the interpretation of the appended claims. Lists and groups of examples provided in the description given above are not exhaustive unless otherwise explicitly stated.

## Claims

1. A conveyor drive unit (1) for driving a conveyor drive machine, the conveyor drive unit comprising:
- a main circuit board (4);
- a grounding plate (2); and
- a housing enclosing the grounding plate (2) and the main circuit board (4);
wherein the main circuit board (4) comprises:
- power components, at least power transistors of the drive unit (1),
- a driver circuit of the power transistors and
- a heat sink adapted for cooling the power transistors,
**characterized by**: the grounding plate (2) having a void,
wherein the grounding plate (2) is adapted to separate an interior of the housing into two portions at opposite sides of the grounding plate (2),
wherein the main circuit board (4) is attached to one side of the grounding plate (2) such that heat sink of
the power transistors extends via the void to the other side of the grounding plate (2),
and wherein the grounding plate (2) comprises a side profile (9) extending perpendicularly from opposite edges of the ground plate to form side surfaces of the housing.

2. The conveyor drive unit according to claim 1, wherein the power components of the main circuit board (4) comprise DC link capacitors of the drive unit (1).

3. The conveyor drive unit according to claim 1 or 2, comprising:
- a fan unit (10) for cooling the power components; and
- a diffusing plate adapted to divide air flow from the fan unit (10) into two sections directed to opposite sides of the grounding plate (2).

4. The conveyor drive unit according to any of the preceding claims, comprising:
- a backup battery control board (3) attached to the grounding plate (2) on the opposite side as the main circuit board (4).

5. The conveyor drive unit according to any of preceding claims, comprising a line filter board (5) attached to the grounding plate (2) on the opposite side as the main circuit board (4).

6. The conveyor drive unit according to any of the preceding claims, wherein the housing is made by casting.

7. The conveyor drive unit according to any of the preceding claims, wherein the housing is made of plastic and the grounding plate (2) is made of metal.

8. The conveyor drive unit according to any of the preceding claims, wherein the main circuit board (4) is electrically connected to the grounding plate (2).

9. The conveyor drive unit according to any of the preceding claims, wherein the grounding plate (2) is made by casting.

10. A conveyor comprising a conveyor drive machine, wherein the conveyor comprises a conveyor drive unit according to any of the preceding claims.

## Patentansprüche

1. Fördererantriebseinheit (1) zum Antreiben einer Fördererantriebsmaschine, die Fördererantriebseinheit umfassend:
- eine Hauptplatine (4);
- eine Erdungsplatte (2); und
- ein Gehäuse, das die Erdungsplatte (2) und die Hauptplatine (4) umschließt;
wobei die Hauptplatine (4) Folgendes umfasst:
- Leistungskomponenten, mindestens Leistungstransistoren der Antriebseinheit (1),
- eine Antriebsschaltung der Leistungstransistoren und
- einen Wärmeableiter, der zum Kühlen der Leistungstransistoren geeignet ist,
**dadurch gekennzeichnet, dass**:
die Erdungsplatte (2) einen Hohlraum aufweist,
wobei die Erdungsplatte (2) dazu geeignet ist, einen Innenraum des Gehäuses in zwei Abschnitte auf gegenüberliegenden Seiten der Erdungsplatte (2) zu trennen,
wobei die Hauptplatine (4) an einer Seite der Erdungsplatte (2) so befestigt ist, dass der Wärmeableiter der Leistungstransistoren sich über den Hohlraum auf die andere Seite der Erdungsplatte (2) erstreckt,
und wobei die Erdungsplatte (2) ein Seitenprofil (9) umfasst, das sich senkrecht von gegenüberliegenden Kanten der Erdungsplatte erstreckt, um Seitenflächen des Gehäuses auszubilden.

2. Fördererantriebseinheit nach Anspruch 1, wobei die Leistungskomponenten der Hauptplatine (4) DC-Zwischenkreiskondensatoren der Antriebseinheit (1) umfassen.

3. Fördererantriebseinheit nach Anspruch 1 oder 2, umfassend:
- eine Gebläseeinheit (10) zum Kühlen der Leistungskomponenten; und
- eine Streuscheibe, die dazu geeignet ist, einen Luftstrom von der Gebläseeinheit (10) in zwei Teile zu teilen, die auf gegenüberliegende Seiten der Erdungsplatte (2) ausgerichtet sind.

4. Fördererantriebseinheit nach einem der vorhergehenden Ansprüche, umfassend:
- eine Sicherungsbatteriesteuerungsplatine (3), die an der Erdungsplatte (2) auf der gegenüberliegenden Seite zur Hauptplatine (4) befestigt ist.

5. Fördererantriebseinheit nach einem der vorhergehenden Ansprüche, umfassend eine Leitungsfilterplatine (5), die an der Erdungsplatte (2) auf der gegenüberliegenden Seite zur Hauptplatine (4) befestigt ist.

6. Fördererantriebseinheit nach einem der vorhergehenden Ansprüche, wobei das Gehäuse mittels Gießen hergestellt wird.

7. Fördererantriebseinheit nach einem der vorhergehenden Ansprüche, wobei das Gehäuse aus Kunststoff hergestellt ist und die Erdungsplatte (2) aus Metall hergestellt ist.

8. Fördererantriebseinheit nach einem der vorhergehenden Ansprüche, wobei die Hauptplatine (4) elektrisch mit der Erdungsplatte (2) verbunden ist.

9. Fördererantriebseinheit nach einem der vorhergehenden Ansprüche, wobei die Erdungsplatte (2) durch Gießen hergestellt ist.

10. Förderer, umfassend eine Fördererantriebsmaschine,
wobei der Förderer eine Fördererantriebseinheit nach einem der vorhergehenden Ansprüche umfasst.

## Revendications

1. Unité d'entraînement de convoyeur (1) pour entraîner une machine d'entraînement de convoyeur, l'unité d'entraînement de convoyeur comprenant :
- une carte de circuit imprimé principale (4) ;
- une plaque de mise à la terre (2) ; et
- un boîtier renfermant la plaque de mise à la terre (2) et la carte de circuit imprimé principale (4) ;
dans laquelle la carte de circuit imprimé principale (4) comprend :
- des composants de puissance, au moins des transistors de puissance de l'unité d'entraînement (1),
- un circuit d'attaque des transistors de puissance et
- un dissipateur thermique adapté pour refroidir les transistors de puissance,
**caractérisée en ce que** :
la plaque de mise à la terre (2) présente un vide,
dans laquelle la plaque de mise à la terre (2) est adaptée pour séparer un intérieur du boîtier en deux parties au niveau de côtés opposés de la plaque de mise à la terre (2), dans laquelle la carte de circuit imprimé principale (4) est fixée à un côté de la plaque de mise à la terre (2) de telle sorte que le dissipateur thermique des transistors de puissance s'étend via le vide vers l'autre côté de la plaque de mise à la terre (2),
et dans laquelle la plaque de mise à la terre (2) comprend un profil latéral (9) s'étendant perpendiculairement à partir des bords opposés de la plaque de mise à la terre pour former des surfaces latérales du boîtier.

2. Unité d'entraînement de convoyeur selon la revendication 1, dans laquelle les composants de puissance de la carte de circuit imprimé principale (4) comprennent des condensateurs de liaison CC de l'unité d'entraînement (1).

3. Unité d'entraînement de convoyeur selon la revendication 1 ou 2, comprenant :
- une unité de ventilation (10) pour refroidir les composants de puissance ; et
- une plaque de diffusion adaptée pour diviser le flux d'air de l'unité de ventilation (10) en deux sections dirigées vers des côtés opposés de la plaque de mise à la terre (2).

4. Unité d'entraînement de convoyeur selon l'une quelconque des revendications précédentes, comprenant :
- une carte de commande de batterie de secours (3) fixée à la plaque de mise à la terre (2) sur le côté opposé an tant que carte de circuit imprimé principale (4).

5. Unité d'entraînement de convoyeur selon l'une quelconque des revendications précédentes, comprenant une carte de filtre de ligne (5) fixée à la plaque de mise à la terre (2) sur le côté opposé en tant que carte de circuit imprimé principale (4).

6. Unité d'entraînement de convoyeur selon l'une quelconque des revendications précédentes, dans laquelle le boîtier est fabriqué par moulage.

7. Unité d'entraînement de convoyeur selon l'une quelconque des revendications précédentes, dans laquelle le boîtier est fait de plastique et la plaque de mise à la terre (2) est faite de métal.

8. Unité d'entraînement de convoyeur selon l'une quelconque des revendications précédentes, dans laquelle la carte de circuit imprimé principale (4) est connectée électriquement à la plaque de mise à la terre (2).

9. Unité d'entraînement de convoyeur selon l'une quelconque des revendications précédentes, dans laquelle la plaque de mise à la terre (2) est fabriquée par moulage.

10. Convoyeur comprenant une machine d'entraînement de convoyeur,
dans lequel le convoyeur comprend une unité d'entraînement de convoyeur selon l'une quelconque des revendications précédentes.
